(19) Europäisches Patentamt
European Patent Office
Office européen des brevets

(11) **EP 2 441 170 B1**

(12) **FASCICULE DE BREVET EUROPEEN**

(45) Date de publication et mention de la délivrance du brevet:
**22.07.2015 Bulletin 2015/30**

(21) Numéro de dépôt: **10724796.7**

(22) Date de dépôt: **07.06.2010**

(51) Int Cl.:
*H03H 9/02* *(2006.01)*    *H03H 9/24* *(2006.01)*
*H03H 3/007* *(2006.01)*    *G01C 19/56* *(2012.01)*

(86) Numéro de dépôt international:
**PCT/EP2010/057928**

(87) Numéro de publication internationale:
**WO 2010/142643 (16.12.2010 Gazette 2010/50)**

(54) **RÉSONATEUR ÉLECTROMÉCANIQUE A ANCRAGE RÉSONANT**

ELECTROMECHANISCHER RESONATOR MIT RESONIERENDER AUFHÄNGUNG

ELECTROMECHANICAL RESONATOR WITH RESONATING ANCHOR

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **09.06.2009 FR 0953820**

(43) Date de publication de la demande:
**18.04.2012 Bulletin 2012/16**

(73) Titulaire: **Commissariat à l'Énergie Atomique et aux Énergies Alternatives
75015 Paris (FR)**

(72) Inventeurs:
• **HENTZ, Sébastien**
  **F-38000 Grenoble (FR)**
• **ARCAMONE, Julien**
  **38950 St Martin le Vinoux (FR)**

(74) Mandataire: **Ilgart, Jean-Christophe et al
BREVALEX
95, rue d'Amsterdam
75378 Paris Cedex 8 (FR)**

(56) Documents cités:
**US-A- 5 095 763        US-A1- 2007 001 783
US-A1- 2007 052 498      US-A1- 2009 153 267**

• KHINE L ET AL: "High-Q bulk-mode SOI square resonators with straight-beam anchors" JOURNAL OF MICROMECHANICS & MICROENGINEERING, INSTITUTE OF PHYSICS PUBLISHING, BRISTOL, GB, vol. 19, no. 1, 1 janvier 2009 (2009-01-01), page 15017, XP020153289 ISSN: 0960-1317
• J. Meroño: "Integration of CMOS-MEMS resonators for radiofrequency applications in the VHF and UHF bands" 4 juillet 2007 (2007-07-04), , XP002601847 http://www.tesisenxarxa.net/TDX/TDX_UAB/TE SIS/AVAILABLE/TDX-1102107-092623/jtm1de1.p df; pages 43-47 - pages 170, 171

**EP 2 441 170 B1**

**Description**

**DOMAINE TECHNIQUE**

L'invention se rapporte à un résonateur électromécanique intégré sur un substrat. La partie mobile du résonateur, c'est-à-dire la partie suspendue, est reliée à la partie fixe (le reste du substrat) par des ancrages qui sont résonants selon l'invention. De manière générale, de tels résonateurs peuvent être utilisés comme structure oscillante pour base de temps notamment dans le domaine de la microinformatique, la téléphonie mobile et les autres appareils mobiles. Ils peuvent aussi être utilisés pour réaliser des capteurs résonants, en particulier pour des capteurs de masse, des capteurs de gaz ou des capteurs biologiques.

**ÉTAT DE LA TECHNIQUE ANTÉRIEURE**

Tous les circuits microélectroniques actuels nécessitent pour leur fonctionnement une horloge. Celle-ci est composée d'un oscillateur et de son électronique associée. L'oscillateur est une structure mécanique, appelée résonateur, maintenue en vibration sur un de ses modes propres et rebouclée sur elle-même via l'électronique associée grâce à des moyens d'actionnement et de détection, générant ainsi un signal d'une fréquence très stable. Dans une grande majorité des cas, cet oscillateur est un morceau de quartz monocristallin, excité sur sa fréquence propre souvent de façon piézoélectrique. Cette combinaison offre l'avantage de la grande stabilité en fréquence du quartz, due à un bruit de phase très limité, et d'une lecture aisée. De plus, des directions de coupe particulières du cristal de quartz offrent une dépendance en température extrêmement faible de la fréquence générée. Par contre, les composants à quartz souffrent d'un défaut rédhibitoire : ils ne sont pas « intégrables », c'est-à-dire que leur procédé d'obtention n'est pas compatible avec des procédés microélectroniques collectifs, ce qui oblige à les fabriquer séparément du circuit CMOS et par conséquent grève considérablement le coût et la taille du composant. Un autre inconvénient notable du quartz relatif à leur utilisation dans des systèmes embarqués autonomes en énergie est leur importante consommation énergétique.

Pour cette raison, son remplacement par des dispositifs intégrables est un domaine de recherche (académique comme industrielle) extrêmement actif, et certaines entreprises commencent même à proposer des produits commerciaux pour certaines applications. La recherche s'est naturellement portée sur des structures silicium, tout d'abord pour des raisons d'intégration évidentes. Mais le silicium est également un matériau potentiellement très avantageux d'un point de vue bruit de phase et donc stabilité en fréquence. Ce bruit de phase est inversement proportionnel à l'énergie de déformation que peut subir la structure. Or la densité d'énergie du silicium est bien supérieure à celle du quartz, ce qui en fait un matériau très intéressant : par exemple, pour des modes de volume comparables, cette densité est de $1,9.10^2$ J.m$^{-3}$ pour le quartz et de $1,8.10^5$ J.m$^{-3}$ pour le silicium.

En revanche, les dispositifs en silicium n'atteignent pas encore les performances souhaitées pour certaines applications en terme de stabilité en fréquence car celle-ci dépend très fortement du gain de transduction de la résonance de la structure. Les dispositifs de la littérature proposent presque tous une transduction capacitive, dont le gain dépend très fortement du gap capacitif g, ainsi que de la raideur de la structure $k$ et de sa fréquence $f_o$. La densité de bruit de phase $B_\phi$ s'écrit alors :

$$B_\phi(f_m) = 10 \log \left( \frac{F k_B T}{P_0} \left( 1 + \frac{f_0^2}{2 f_m^2} \frac{1}{Q^2} \right) \left( 1 + \frac{f_C}{f_m} \right) \right) \quad \text{avec} \quad \frac{F k_B T}{P_0} \propto \frac{g^2}{k f_0} k_B T$$

avec :

$f_m$ = décalage fréquentiel par rapport à la porteuse
$F$ = facteur de bruit de l'électronique
$k_B$ = constante de Boltzmann
$T$ = température
$P_o$ = puissance transmise dans le résonateur
$Q$ = facteur de qualité
$f_c$ = fréquence de transmission entre le bruit proche porteuse et le bruit plancher

Afin de satisfaire les performances souhaitées, il est donc de première importance d'obtenir des structures très raides ($k$ grand) tout en favorisant leur déplacement par rapport au gap, c'est-à-dire qu'il est également primordial de diminuer ce gap de transduction $g$ et d'obtenir un facteur de qualité $Q$ le plus grand possible.

2

On trouve dans la littérature scientifique plusieurs types de résonateurs réalisés à partir du silicium.

Il existe des structures en anneau ancré au centre, du type dit « SiTime » (du nom de la société SiTime Corporation). On peut se référer à ce sujet au site www.sitime.com.

L'article « Square-Extensional Mode Single-Crystal Silicon Micromechanical Resonator for Low-Phase-Noise Oscillator Applications » de V. Kaajakari, IEEE Electron Devices Letters, vol. 25, n°4, avril 2004, pages 173 à 175, divulgue un résonateur réalisé à partir d'une plaque carrée.

L'article « 60 MHz wine-glass micromechanical-disk reference oscillator », de Yu-Wei Lin et al., ISSCC, Digest of Techical Papers, 530, 15-19 février 2004, pages 322 et 323, divulgue un résonateur comprenant un disque avec deux ancrages extérieurs (latéraux) en mode dit « wine-glass ».

L'article « A low phase noise 100 MHz silicon BAW reference oscillator » de K. Sundaresan et al., IEEE CICC, 10-13 septembre 2006, pages 841 à 844, divulgue un résonateur formé à partir d'une plaque rectangulaire à ancrages extérieurs.

Les plaques et disques comportant des ancrages extérieurs ou en leur centre peuvent être utilisés sur leur mode de Lamé, « wine-glass » ou extensionnel, voire d'autres modes, comme des modes d'ordres supérieurs.

Comme précisé précédemment, il est important d'optimiser le facteur de qualité afin d'obtenir de meilleurs bruits de phase. Le facteur de qualité caractérise les pertes ou la dissipation d'énergie qui ont plusieurs sources :

- la limite fondamentale, la dissipation thermoélastique, l'amortissement « matériau »,
- les pertes dans les supports (propagation acoustique dans le milieu qui conduit à la dissipation de l'onde dans le substrat ou le support du dispositif),
- les pertes de surface,
- les pertes visqueuses (amortissement de l'air) que l'on peut réduire, voire éliminer en encapsulant sous vide le dispositif.

Aux tailles considérées et en travaillant à pression réduite, les pertes dans les supports et la dissipation thermoélastique sont prépondérantes. La seconde étant une limite fondamentale, il faut tout faire pour diminuer les pertes aux supports, tout en favorisant le mouvement de la structure. A cet effet, la littérature ne présente que très peu de solutions. Certains utilisent un seul ancrage situé sous la structure et en son centre, quand celui-ci est un point nodal. C'est une solution favorable d'un point de vue des performances, mais qui malheureusement exige l'utilisation d'un procédé de fabrication complexe, puisque des étapes et niveaux supplémentaires de lithographie sont nécessaires à l'obtention de cet ancrage central. Les autres dispositifs utilisent des ancrages extérieurs (latéraux) à la structure mais cela gêne son mouvement, même de façon minime.

Dans le cas d'ancrages latéraux, peu de solutions sont apportées pour minimiser cette résistance au mouvement. Par exemple, dans le cas d'une plaque en mode extensionnel, certains proposent une barre transversale utilisée en ressort de flexion pour diminuer la raideur de l'ancrage. Mais on ne peut pas diminuer de façon trop importante la raideur des ancrages pour des raisons de robustesse (collage de la structure lors de sa libération ou sous choc). D'autres placent les ancrages aux points nodaux (point où le champ de déplacement du mode est nul) du mode propre de la structure. Le cas idéal requiert des ancrages parfaitement ponctuels, ce qui dans la pratique est impossible à réaliser. Il subsiste donc dans tous les cas une résistance au mouvement.

Il est donc nécessaire de trouver des solutions nouvelles pour diminuer la perte acoustique aux ancrages et pour gêner le moins possible le mouvement de la structure.

Le document « High-Q bulk-mode SOI square resonators with straight-beam anchors » de L. Khine et al., J. Micromech. Microeng., Vol. 19, N° 1, 1er janvier 2009, 015017, divulgue des structures d'ancrage résonantes pour les modes wine-glass et Lamé. Ces structures d'ancrage sont constituées d'une poutre simple, dont une extrémité est reliée à la structure résonante, utilisée sur un mode de flexion particulier. Le découplage obtenu (entre support mécanique au substrat et autorisation de mouvements d'amplitude de vibration suffisante) n'est pas particulièrement efficace.

## EXPOSÉ DE L'INVENTION

L'idée qui est à la base de l'invention est :

1) de proposer des ancrages extérieurs (latéraux) pour conserver un procédé de fabrication le plus simple possible,
2) d'utiliser des ancrages raides pour obtenir des structures robustes,
3) en même temps, de favoriser le mouvement de la structure ainsi qu'un grand désaccord d'impédance acoustique structure/ancrages afin de minimiser la perte aux ancrages. L'impédance acoustique caractérise la résistance qu'un milieu oppose à sa mise en mouvement lorsqu'il est traversé par une onde acoustique. Elle est définie comme le rapport de la pression acoustique sur la vitesse de déplacement locale dans un milieu. Lorsqu'une onde acoustique rencontre l'interface séparant deux milieux d'impédances acoustiques différents, une partie de l'onde est transmise dans l'autre milieu tandis qu'une autre partie se réfléchit sur l'interface. La notion d'impédance acoustique permet d'étudier complètement et quantitativement ce phénomène et d'estimer les quantités d'énergie acoustique transmises et réfléchies. Dans le cas de l'invention, il s'agit de minimiser l'énergie transmise. Un grand désaccord peut être obtenu en changeant brusquement les dimensions transversales ou en utilisant des matériaux différents.

Pour répondre à ces trois requêtes, on propose d'utiliser des ancrages qui résonnent également sur un mode à la même fréquence de résonance que la structure considérée. Ainsi leur raideur statique peut être importante, mais leur mouvement est amplifié d'un rapport égal au facteur de qualité de leur résonance, potentiellement important.

On peut imaginer un grand nombre d'ancrages résonants, puisque les procédés de photolithographie permettent de définir n'importe quelle forme dans le plan. Ces ancrages sont également valables pour tout type de structure résonante, avantageusement sur un mode dans le plan, mais aussi hors plan. Ces ancrages ne nécessitent pas d'excitation spécifique, puisque le couplage acoustique avec la structure principale suffira à les exciter.

Les deux modes de pertes d'énergie et donc de dégradation du facteur de qualité sont les pertes aux ancrages et les pertes thermoélastiques. Pour limiter les premières, on peut placer les ancrages au substrat aux points nodaux du mode de résonance utilisé de la structure, ou au contraire faciliter le déplacement des points d'ancrage de la structure résonante, c'est-à-dire utiliser des structures d'ancrage de raideur effective faible pour solliciter le moins possible le substrat, d'où l'idée d'ancrages résonants.

Un mode extensionnel ne comprend qu'un seul point nodal, au centre de la structure. Un ancrage central sous la structure imposerait de grandes contraintes au procédé de fabrication, en terme de complexité et d'alignement des différents niveaux. On va donc plutôt chercher à favoriser le déplacement des points d'ancrage de la structure sur son bord, c'est-à-dire là où le déplacement est maximum. Les modes wine-glass (disque) et Lamé (carré) en revanche présentent plusieurs points nodaux sur leur bord, qui pourront être les points d'ancrage de la structure. Dans les deux cas on a intérêt à utiliser des ancrages latéraux, ce qui donne plus de liberté dans la conception de ces ancrages, ancrages qui peuvent donc être résonants.

Un premier objet de l'invention consiste en un résonateur électromécanique réalisé sur un substrat tel que défini par la revendication 1.

La structure d'ancrage peut être réalisée tout ou partie à partir du substrat ou par un élément déposé sur ce dernier.

La structure suspendue peut être une structure choisie parmi un disque, une plaque carrée, une plaque rectangulaire, un anneau et une ellipse. Il peut s'agir d'un disque ou d'une ellipse résonant en mode « Wine-Glass ». Il peut s'agir d'une plaque résonant en son mode Lamé.

Un deuxième objet de l'invention consiste en un procédé conforme à la revendication 5 de réalisation d'un résonateur électromécanique tel que défini ci-dessus

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 est une vue de dessus d'une plaque carrée vibrant en mode extensionnel avec une structure d'ancrage constituée de quatre poutres, selon un exemple de réalisation ne faisant pas partie de l'invention,
- la figure 2 est une vue de dessus et partielle d'un disque résonant en mode extensionnel avec ancrages résonants en T, selon un exemple de réalisation ne faisant pas partie de l'invention,
- la figure 3 est une vue de dessus et partielle d'une plaque carrée résonant sur son mode de Lamé et comportant des ancrages résonant sur leur premier mode de flexion, selon un exemple de réalisation ne faisant pas partie de l'invention,
- la figure 4 est une vue de dessus et partielle d'un disque résonant sur le mode « Wine-Glass » avec ancrages résonants en T, selon l'invention,
- la figure 5 est une vue de dessus d'une plaque rectangulaire résonant sur son premier mode de volume quasi-directionnel avec des ancrages résonant sur leur mode longitudinal simple, selon un exemple de réalisation ne faisant pas partie de l'invention,
- la figure 6 est une vue de dessus et partielle d'une plaque carrée avec une structure d'ancrage formée d'un diapason, selon un exemple de réalisation ne faisant pas partie de l'invention,
- la figure 7 est une vue de dessus et partielle d'une plaque carrée avec des ancrages en créneaux, selon un exemple de réalisation ne faisant pas partie de l'invention,
- la figure 8 est une vue de dessus et partielle d'un anneau avec un ancrage hors extrémités de poutre, selon un exemple de réalisation ne faisant pas partie de l'invention,
- les figures 9A à 9D illustrent un premier mode de réalisation de l'invention,

EP 2 441 170 B1

- les figures 10A à 10G illustrent un deuxième mode de mise en oeuvre de l'invention.

## EXPOSÉ DÉTAILLÉ DE MODES DE RÉALISATION PREFERES

D'une manière générale, l'oscillateur selon la présente invention comprend la structure résonante proprement dite générant la fréquence d'horloge et une structure d'ancrage que l'on cherche à faire résonner à la même fréquence que la structure résonante. La démarche de conception du résonateur peut être la suivante :

- choix de la fréquence du signal d'horloge à générer,
- choix de la forme de la structure suspendue (carrée, circulaire, en anneau, de forme quelconque, ...),
- choix des dimensions de la structure suspendue afin qu'un de ses modes propres corresponde à la fréquence choisie,
- choix a posteriori de la forme et de l'emplacement de la structure d'ancrage que l'on souhaite faire résonner à la même fréquence que la structure suspendue,
- modélisation de la structure suspendue et de la structure d'ancrage afin de déterminer les dimensions de la structure d'ancrage considérée afin que l'ensemble des deux structures résonne à la même fréquence.

Sauf dans le cas de formes et de modes bien spécifiques, il est nécessaire de modéliser la structure suspendue dans un logiciel afin de déterminer les dimensions avec précisons. L'homme du métier pourra utiliser un logiciel de simulation structurelle, tel que par exemple ceux disponibles auprès des sociétés Comsol, Ansys et Abaqus, permettant de déterminer les dimensions géométriques adéquates pour obtenir une fréquence de résonance donnée pour une forme donnée et un matériau donné.

La forme de la structure d'ancrage peut être choisie afin de maximiser le désaccord acoustique, de favoriser la simplicité du procédé de fabrication, de favoriser le mouvement de la structure suspendue ... Son dimensionnement peut être déterminé par l'un des logiciels cités plus haut.

Il est possible que la fréquence de la structure suspendue soit légèrement modifiée par rapport à la modélisation par l'ajout d'ancrages résonants. Ceci impose une correction de ses dimensions et d'itérer afin de trouver les bonnes dimensions de la structure suspendue et de la structure d'ancrage.

On va maintenant décrire plusieurs modes de réalisation. Par souci de simplicité, on prendra le cas d'une structure suspendue de forme carrée ou circulaire, sachant que l'homme du métier pourra appliquer de la même façon ce principe à d'autres formes de structures suspendues.

1) Disque ou plaque carrée résonant en mode extensionnel avec des ancrages résonant sur leur mode longitudinal (exemple de réalisation ne faisant pas partie de l'invention)

Dans le cas d'une plaque carrée, la fréquence $f_{EXT\_P}$ du mode extensionnel est :

$$f_{EXT\_P} = \frac{1}{2L}\sqrt{\frac{E_{2D}}{\rho}} \qquad (1)$$

où $L$ est la longueur du côté de la plaque, $\rho$ et $E_{2D}$ sont respectivement la densité et le module d'Young effectif en biaxial du matériau constituant la plaque pour la direction de vibration considérée. On peut se référer à ce sujet à l'article « Square-Extensional Mode Single-Crystal Silicon Micromechanical Resonator for Low-Phase-Noise Oscillator Applications » de V. Kaajakari, IEEE Electron Devices Letters, vol. 25, n°4, avril 2004, pages 173 à 175.

Dans le cas d'un disque, la fréquence $f_{EXT\_D}$ du mode extensionnel d'un disque est :

$$f_{EXT\_D} = \frac{K}{2R}\sqrt{\frac{E}{\rho}} \qquad (2)$$

où $K$ dépend du module de Poisson selon une direction cristallographique donnée, $R$ est le rayon du disque, $\rho$ et E sont respectivement la densité du matériau constituant le disque et le module de Young pour la direction de vibration considérée.

La fréquence $f_L$ du mode longitudinal d'une poutre encastrée-libre est :

$$fL = \frac{1}{4Lp} \sqrt{\frac{E}{\rho}} \qquad (3)$$

où $Lp$ est la longueur de la poutre, $\rho$ et $E$ sont respectivement la densité du matériau constituant la poutre et le module de Young pour la direction de vibration considérée.

En termes de dimensionnement, pour bénéficier des avantages cités d'un ancrage résonant avec la structure suspendue, il s'agit donc d'ajuster les dimensions du disque ou de la plaque et de la poutre d'ancrage de manière à égaliser soit les deux fréquences des formules (1) et (3), soit les deux fréquences des formules (2) et (3). Cependant, ces formules analytiques dépendent fortement des conditions aux limites. Il est donc nécessaire d'ajuster les dimensions grâce à des simulations numériques basées sur la méthode des Eléments Finis.

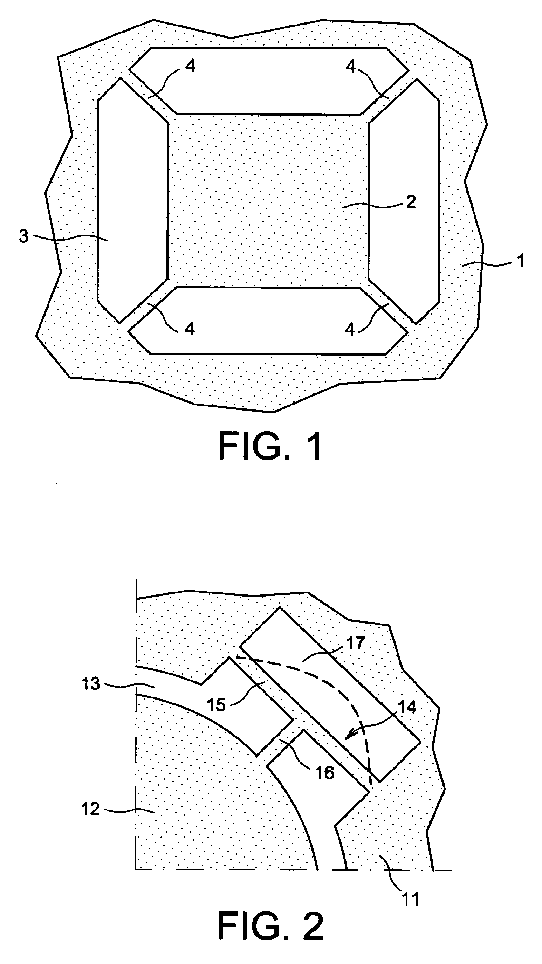

La figure 1 représente, vue de dessus, une plaque carrée vibrant en mode extensionnel avec une structure d'ancrage constituée de quatre poutres. On reconnaît un substrat 1 dans lequel a été réalisée une structure suspendue constituée d'une plaque carrée 2 suspendue au-dessus d'une cavité 3, réalisée dans le substrat 1, par quatre poutres 4. La plaque carrée 2 et les poutres 4 sont dimensionnées en respectant les formules (1) et (3) ci-dessus.

2) Disque ou plaque carré résonant en mode extensionnel avec ancrages résonants en T (exemple de réalisation ne faisant pas partie de l'invention)

On peut également utiliser des ancrages en T pour augmenter encore l'effet de désaccord (en anglais « mismatch ») d'impédance avec une barre transversale et afin d'opposer le moins de résistance possible au mouvement de la structure suspendue. Pour cela, la barre transversale d'un ancrage est dimensionnée de manière à résonner sur son premier mode de flexion comme le montre la figure 2 où seul un quart de la structure suspendue a été représentée.

La fréquence $fp$ du premier mode de flexion d'une poutre bi-encastrée est :

$$fp = \frac{6{,}46}{2\pi} \sqrt{\frac{E}{\rho}} \frac{h}{Lp^2} \qquad (4)$$

où $\rho$ et $E$ sont respectivement la densité du matériau constituant la poutre et le module de Young pour la direction de vibration considérée, $h$ est la largeur de la poutre dans la direction de vibration, $Lp$ est sa longueur.

Il s'agit donc d'ajuster les dimensions du disque ou de la plaque et de la poutre bi-encastrée transverse permettant d'égaliser soit les deux fréquences des formules (1) et (4), soit les deux fréquences des formules (2) et (4). A noter que la seconde poutre reliant le disque ou la plaque et la poutre transverse modifie le comportement intrisèque de la poutre transverse, il faut donc faire un ajustage final des dimensions en menant une simulation par éléments finis de la structure.

La figure 2, vue de dessus et partiellement, représente un disque résonant en mode extensionnel avec ancrages résonants en T. On reconnaît un substrat 11 dans lequel a été réalisée une structure suspendue constituée d'un disque 12 (dont seulement un quart est représenté) suspendu au-dessus d'une cavité 13, réalisée dans le substrat 11, par une structure d'ancrage comprenant quatre éléments identiques 14 disposés à 90° les uns des autres (un seul élément est représenté). Chaque élément 14 comprend une poutre transversale 15 bi-encastrée au substrat 11 et reliée au disque 12 par une poutre 16 disposée selon un rayon du disque 12. Le trait interrompu 17 représente une position de l'axe de la poutre 15 en cours de vibration.

3) Disque résonant sur son mode « Wine-Glass » ou plaque carrée résonant sur mode de Lamé, comportant des ancrages résonant sur leur premier mode de flexion (exemple de réalisation ne faisant pas partie de l'invention)

La fréquence $f_{WG\_D}$ du mode « wine-Glass » d'un disque est :

$$f_{WG\_D} = \frac{k}{2\pi R} \sqrt{\frac{E}{\rho(1-v^2)}} \qquad (5)$$

où $k$ dépend du module de Poisson $v$ selon une direction cristallographique donnée, $R$ est le rayon du disque, $\rho$ et $E$ sont respectivement la densité du matériau constituant le disque et le module de Young pour la direction de vibration considérée. Il s'agit donc d'égaliser la formule (5) avec la formule donnant la fréquence d'une poutre bi-encastrée (formule (4) donnée ci-dessus).

La fréquence $f_{LAME\_P}$ du mode de Lamé d'une plaque carrée est :

$$f_{LAME\_P} = \frac{1}{\sqrt{2}L}\sqrt{\frac{G}{\rho}} \qquad (6)$$

où $L$ est la longueur de l'arête de la plaque, $G$ est son module de cisaillement et $\rho$ est la densité du matériau constituant la plaque.

Il s'agit donc d'égaliser la formule (6) avec la formule donnant la fréquence d'une poutre bi-encastrée (formule (4) donnée ci-dessus).

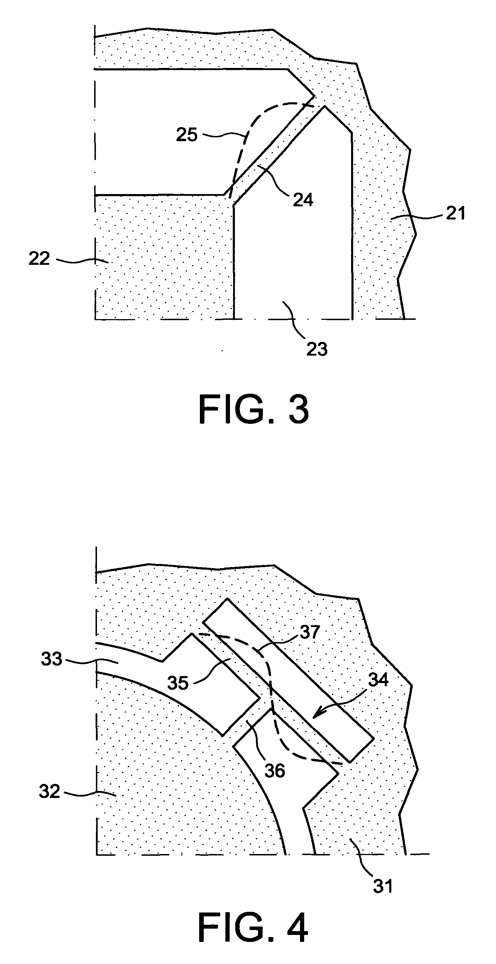

La figure 3 est une vue de dessus et partielle d'une plaque carrée résonant sur son mode de Lamé et comportant des ancrages résonant sur leur premier mode de flexion. On reconnaît un substrat 21 dans lequel a été réalisée une structure suspendue constituée d'une plaque carrée 22 (dont seulement un quart est représenté) suspendue au-dessus d'une cavité 23, réalisée dans le substrat 21, par une structure d'ancrage comprenant quatre poutres 24 reliant les sommets de la plaque carrée 22 au substrat 21 (une seule poutre est représentée). Le trait interrompu 25 représente une position de l'axe de la poutre 24 en cours de vibration.

4) Disque résonant sur son mode « Wine-Glass » ou plaque carrée résonant sur mode de lamé, avec ancrages résonants en T (exemple de réalisation conforme à l'invention)

L'étude des modes « Wine-Glass » et Lamé montre que les points quasi-nodaux situés sur les contours du résonateur (là où son placés les ancrages externes latéraux) ne connaissent pas de translation mais seulement une très légère rotation. La barre transversale de l'ancrage est dimensionnée de façon à résonner sur son deuxième mode de flexion (voir la figure 4). De cette manière, un désaccord (ou « mismatch ») additionnel d'impédance est apporté par rapport à un ancrage simple. Par ailleurs, le point milieu de la poutre transverse de l'ancrage en T est maintenu fixe mais est censé faciliter cette faible rotation.

La fréquence du deuxième mode de flexion d'une poutre bi-encastrée est :

$$fp_2 = \frac{17{,}8}{2\pi}\sqrt{\frac{E}{\rho}}\,\frac{h}{Lp^2} \qquad (7)$$

où $\rho$ et $E$ sont respectivement la densité du matériau constituant la poutre et le module de Young pour la direction de vibration considéré, $h$ est la largeur de la poutre dans la direction de vibration, $Lp$ est sa longueur.

Dans le cas d'une structure suspendue en forme de disque, il s'agit donc d'égaliser la formule (7) avec la formule donnant la fréquence d'un disque résonant sur son mode « Wine-Glass » (formule (5) donnée ci-dessus).

La figure 4, vue de dessus et partiellement, représente un disque résonant sur le mode « Wine-Glass » avec ancrages résonants en T. On reconnaît un substrat 31 dans lequel a été réalisée une structure suspendue constituée d'un disque 32 (dont seulement un quart est représenté) suspendu au-dessus d'une cavité 33, réalisée dans le substrat 31, par une structure d'ancrage comprenant quatre parties 34 disposées à 90° les unes des autres (une seule partie est représentée). Chaque partie 34 comprend une poutre transversale 35 bi-encastrée au substrat 31 et reliée au disque 32 par une poutre 36 disposée selon un rayon du disque 32. Le trait interrompu 37 représente une position de l'axe de la poutre 35 en cours de vibration.

Dans le cas d'une structure suspendue en forme de plaque, il s'agit donc d'égaliser la formule (7) avec la formule donnant la fréquence d'une plaque résonant sur son mode de Lamé (formule 6) donnée ci-dessus).

5) Plaque rectangulaire, de type SiBAR, résonant sur son premier mode de volume quasi-unidirectionnel avec ancrages résonant sur leur mode longitudinal simple (exemple de réalisation ne faisant pas partie de l'invention)

L'expression SiBAR signifie « Silicon Bulk Acoustic Wave Resonator ».

La fréquence de résonance $f_{SiBAR}$ du mode longitudinal simple d'une plaque rectangulaire est :

$$f_{SiBAR} = \frac{1}{2L}\sqrt{\frac{E}{\rho}} \qquad\qquad (8)$$

où $L$ est la longueur de la plaque dans la direction de vibration, $\rho$ et $E$ sont respectivement la densité du matériau constituant la plaque et le module de Young pour la direction de vibration considérée.

Concernant la résonance d'une telle plaque, on pourra se référer à l'article déjà cité « A low phase noise 100 MHz silicon BAW reference oscillator » de K. Sundaresan et al., IEEE CICC, 10-13 septembre 2006, pages 841 à 844.

Il s'agit donc d'égaliser la formule (8) avec la formule donnant la fréquence du mode longitudinal d'une poutre encastrée-libre (formule (3) donnée ci-dessus).

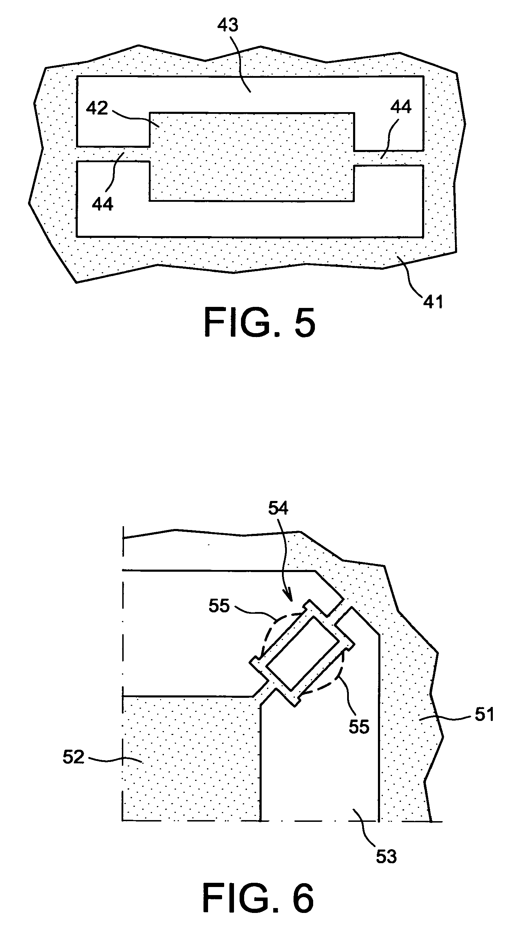

La figure 5 représente, vue de dessus, une plaque rectangulaire résonant sur son premier mode de volume quasi-unidirectionnel avec des ancrages résonant sur leur mode longitudinal simple. On reconnaît un substrat 41 dans lequel a été réalisée une structure suspendue constituée d'une plaque rectangulaire 42 suspendue au-dessus d'une cavité 43, réalisée dans le substrat 41, par une structure d'ancrage comprenant deux poutres 44 disposées selon le grand axe de symétrie de la plaque rectangulaire 42.

6) <u>Disque ou plaque carrée avec ancrage diapason</u> (exemple de réalisation ne faisant pas partie de l'invention)

En tant que structure résonante, le diapason possède la caractéristique de minimiser ses pertes dans les ancrages. Son association avec une structure suspendue résonante permet donc d'obtenir également une barrière à la propagation acoustique.

La fréquence de résonance d'un diapason est celle d'une poutre bi-encastrée seule. Il s'agit donc d'égaliser la fréquence de résonance d'un disque ou d'une plaque carrée constituant la structure suspendue avec la fréquence de résonance d'un diapason.

La figure 6 représente, vue de dessus et partiellement, une plaque carrée avec une structure d'ancrage formée de diapasons. On reconnaît un substrat 51 dans lequel a été réalisée une structure suspendue constituée d'une plaque carrée 52 (dont seulement un quart est représenté) suspendue au-dessus d'une cavité 53, réalisée dans le substrat 51, par une structure d'ancrage comprenant quatre éléments 54 (un seul élément est représenté). Chaque élément 54 comprend un diapason et relie un sommet de la plaque carrée 52 au substrat 51. Les traits interrompus 55 représentent des positions du diapason en cours de vibration.

7) <u>Disque ou plaque carrée avec des ancrages en créneaux</u> (exemple de réalisation ne faisant pas partie de l'invention)

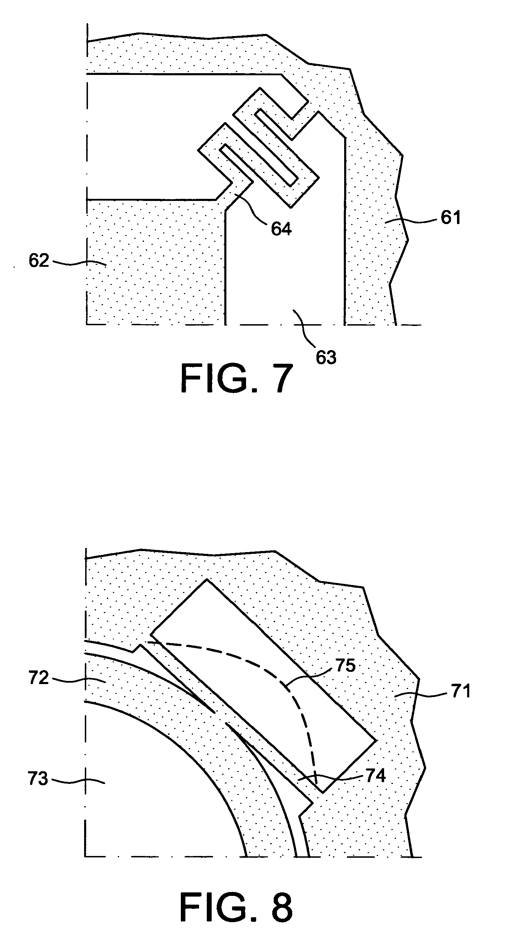

La figure 7 représente, vue de dessus et partiellement, une plaque carrée avec des ancrages en créneaux. On reconnaît un substrat 61 dans lequel a été réalisée une structure suspendue constituée d'une plaque carrée 62 (dont seulement un quart est représenté) suspendue au-dessus d'une cavité 63, réalisée dans le substrat 61, par une structure d'ancrage comprenant quatre éléments 64 (un seul élément est représenté). Chaque élément 64 résonant a une forme en créneaux ou en serpentin ou en « grecques » et relie un sommet de la plaque carrée 62 au substrat 61.

8) <u>Anneau avec ancrages placés hors extrémité de poutre</u> (exemple de réalisation ne faisant pas partie de l'invention)

La figure 8 représente, vu de dessus et partiellement, un anneau avec un ancrage hors extrémité de poutres. On reconnaît un substrat 71 dans lequel a été réalisée une structure suspendue constituée d'un anneau 72 (dont seulement un quart est représenté) suspendu au-dessus d'une cavité 73, réalisée dans le substrat 71, par une structure d'ancrage comprenant quatre poutres 74 (une seule poutre est représentée). Chaque poutre 74 est bi-encastrée au substrat et est disposée pour supporter l'anneau 72 de façon tangente. Les poutres 74 sont disposées régulièrement autour de l'anneau 72. Le trait interrompu 75 représente une position de la poutre 74 en cours de vibration.

On va maintenant décrire deux modes de fabrication de l'invention. Ces procédés comprennent des étapes de réalisation d'électrodes d'excitation et de détection (par lecture capacitive). Les techniques de mesure classiques du domaine peuvent être mises en place. Cependant, tout autre type de transduction peut également être utilisée dans les résonateurs selon l'invention.

Premier mode de fabrication de l'invention

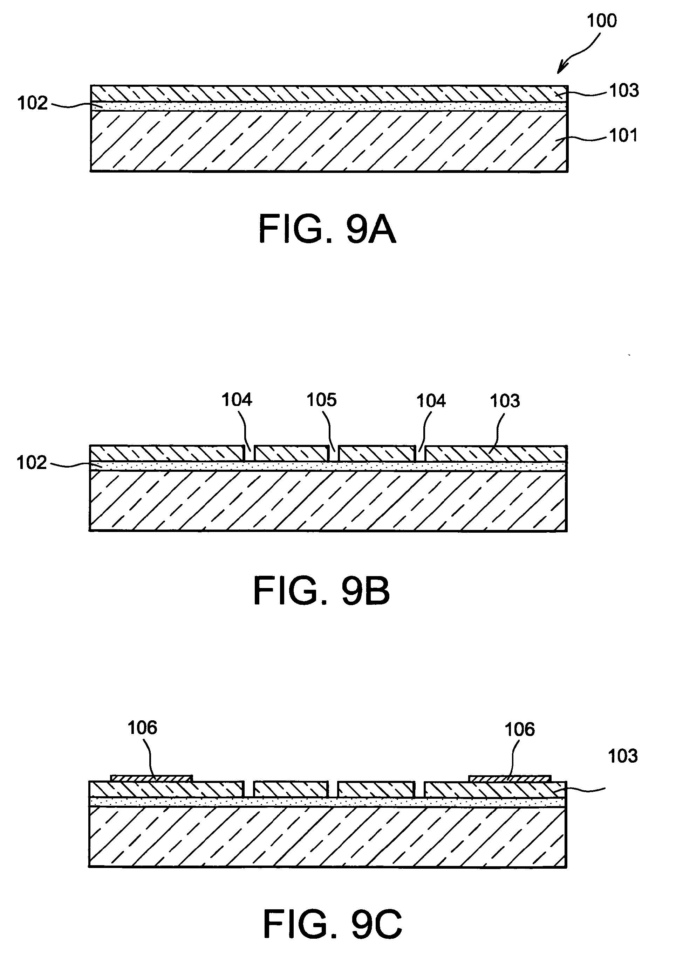

Les figures 9A à 9D illustrent un premier mode de fabrication de l'invention. Ce mode de réalisation met en oeuvre une gravure ionique réactive (ou « deep RIE » en anglais).

La figure 9A montre, vu en coupe transversale, un substrat dit semiconducteur-sur-isolant (acronyme SOI en anglais) 100 constitué d'un support 101 supportant respectivement une couche d'isolant enterrée 102 et une couche mince de matériau semiconducteur 103. A titre d'exemple, le support 101 est en silicium, la couche enterrée 102 est en oxyde de silicium et la couche mince 103 est en silicium monocristallin. La structure suspendue et la structure d'ancrage seront réalisées dans la couche mince 103. Leur libération sera obtenue par gravure sacrificielle de la couche enterrée 102.

On procède à une étape de photolithographie de la couche mince 103 et à une étape de gravure sèche de cette couche mince avec arrêt sur la couche enterrée 102. Le résultat obtenu est montré à la figure 9B. Les tranchées 104 permettent de délimiter la future structure suspendue et la future structure d'ancrage et éventuellement tout ou partie des moyens d'excitation et de détection (pistes, électrodes). Le trou 105 est un trou central réalisé dans la structure suspendue et permettant de diminuer la distance de gravure de la couche enterrée 102 lors de l'étape de libération.

Des électrodes d'excitation et de détection sont ensuite mises en place. Pour cela, on procède d'abord au dépôt d'une couche métallique (par exemple une couche d'AlSi), puis à une étape de photolithographie de la couche métallique et enfin à sa gravure pour fournir les électrodes. La figure 9C ne montre que deux électrodes 106.

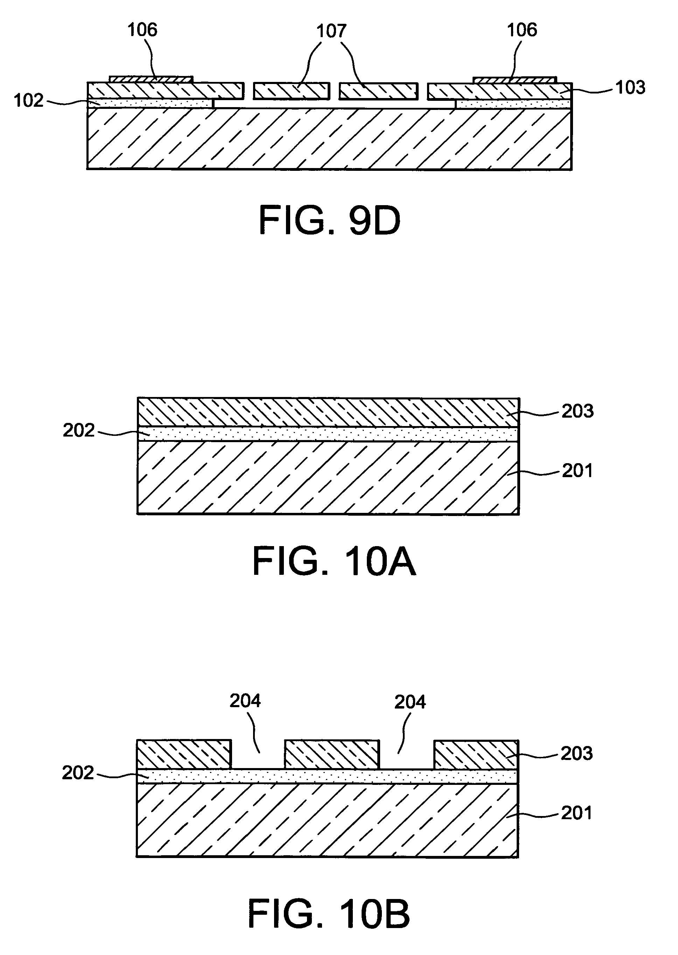

La dernière étape consiste à graver partiellement la couche enterrée 102 pour permettre la libération de la structure suspendue 107 (voir la figure 9D) et de la structure d'ancrage (non visible sur la figure 9D). La couche d'oxyde de silicium 102 est par exemple gravée partiellement par de l'acide fluorhydrique (HF) en phase vapeur. Cette gravure partielle est obtenue par limitation du temps de gravure.

Deuxième mode de réalisation de l'invention

Les figures 10A à 10G illustrent un deuxième mode de réalisation de l'invention. Ce mode de réalisation met en oeuvre un dépôt d'oxyde sacrificiel conforme.

La figure 10A montre, vu en coupe transversale, un substrat dit semiconducteur-sur-isolant 200. A titre d'exemple, comme pour le premier mode de réalisation, le substrat 200 comprend un support 201 en silicium supportant respectivement une couche enterrée 202 en oxyde de silicium et une couche mince 203 en silicium monocristallin.

On procède à une étape de photolithographie de la couche mince 203 et à une étape de gravure sèche de cette couche mince avec arrêt sur la couche enterrée 202. Le résultat obtenu est montré à la figure 10B. Les tranchées 204 permettent de délimiter la future structure suspendue et la future structure d'ancrage.

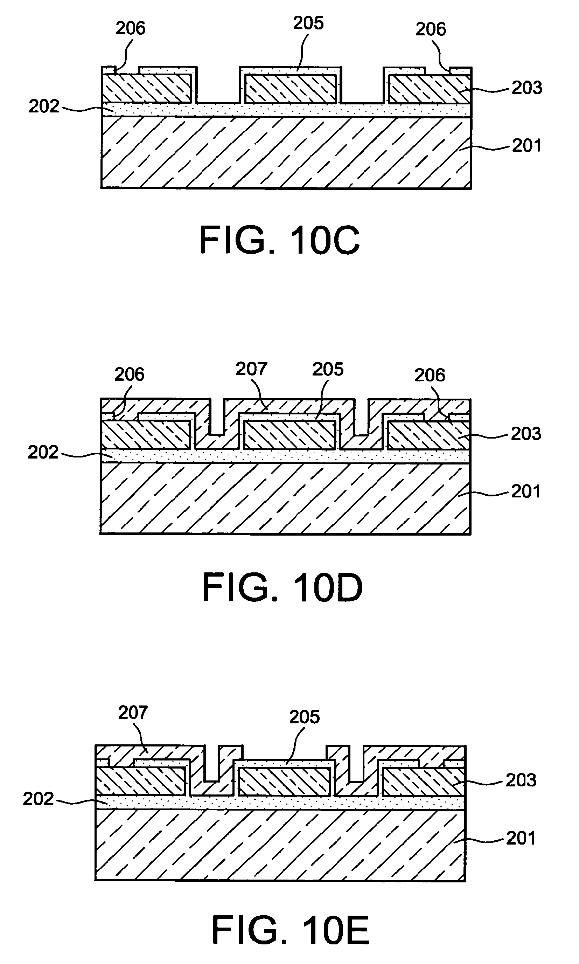

On dépose ensuite une couche d'oxyde fin conforme 205 (voir la figure 10C) sur toute la surface de la structure obtenue précédemment. Il s'agit par exemple d'une couche d'oxyde de silicium déposée par la méthode dite du dépôt chimique en phase vapeur (acronyme CVD en anglais). Par photolithographie et gravure de la couche d'oxyde conforme 205, on définit des ouvertures qui serviront à ancrer mécaniquement et à éventuellement contacter électriquement la couche supérieure (207, voir ci-après) avec la couche mince 203. Cette gravure, définissant des trous 206, a été menée jusqu'à révéler la couche mince 203 au fond des trous 206.

On procède ensuite à une épitaxie de silicium sur le substrat. C'est ce que montre la figure 10D. On obtient une couche de silicium polycristallin 207 du fait de sa croissance sur la couche d'oxyde 205. Localement, les trous 206 ont permis une croissance de silicium monocristallin dans les ouvertures débouchant sur la couche mince 203.

On procède ensuite à la photolithographie de la couche de silicium polycristallin 207 et à sa gravure pour prévoir la libération de la structure suspendue et de la structure d'ancrage, en donnant accès à la couche d'oxyde 205 située sur la structure suspendue et la structure d'ancrage (voir la figure 10E).

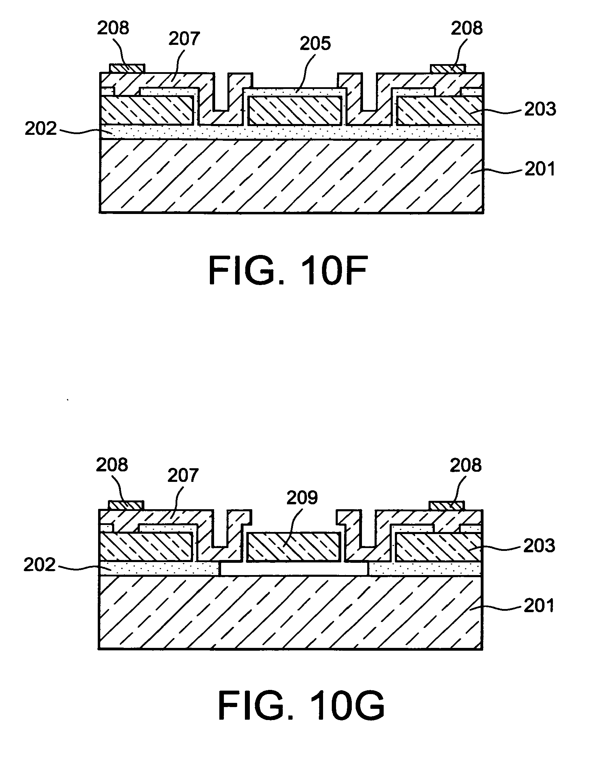

L'étape suivante consiste à déposer une couche métallique sur le substrat, à la photolithographier et à la graver, par exemple par gravure humide, pour obtenir des contacts métalliques (voir la figure 10F).

On procède ensuite à la gravure de l'oxyde de silicium par de l'acide fluorhydrique (HF) en phase vapeur. La gravure débute sur la face libre de la couche d'oxyde fin conforme 205, c'est-à-dire à l'emplacement de la future structure suspendue et de la future structure d'ancrage. Elle est poursuivie jusqu'à obtenir la libération complète de la structure suspendue et de la structure d'ancrage (voir la figure 10G). Sur la figure 10G, seule la structure suspendue 209 est visible.

## Revendications

1. Résonateur électromécanique réalisé sur un substrat, comprenant :

   - une structure suspendue (32) réalisée au moins en partie à partir du substrat (31), destinée à être mise en vibration pour résonner à au moins une fréquence de résonance propre à la structure suspendue,
   - une structure d'ancrage (34) pour ancrer la structure suspendue, par au moins une zone de sa périphérie, au reste du substrat, la structure d'ancrage étant dimensionnée pour résonner à ladite fréquence de résonance,
   - des moyens d'excitation de la structure suspendue pour la faire vibrer à ladite fréquence de résonance,
   - des moyens de détection de la fréquence de vibration de la structure suspendue,

**caractérisé en ce que** :

- la structure d'ancrage comprend au moins un élément en T (34) formé d'une première poutre bi-encastrée (35) solidaire du substrat (31) et une deuxième poutre (36) dont une première extrémité est solidaire de la première poutre et dont une deuxième extrémité est solidaire de la structure suspendue (32),
- la structure suspendue résonne en mode Lamé ou en mode wine-glass, la première extrémité de la deuxième poutre (36) est solidaire de la première poutre (35) à un noeud de vibration de la première poutre (35) et la deuxième extrémité de la deuxième poutre (36) est solidaire de la structure suspendue (32) à un point nodal de celle-ci.

2. Résonateur électromécanique selon la revendication 1, dans lequel la structure suspendue est une structure choisie parmi un disque, une plaque carrée, une plaque rectangulaire, un anneau et une ellipse.

3. Résonateur électromécanique selon la revendication 2, dans lequel la structure suspendue est un disque ou une ellipse résonant sur son mode « Wine-Glass » (32).

4. Résonateur électromécanique selon la revendication 2, dans lequel la structure suspendue est une plaque carrée ou rectangulaire résonant sur son mode dit de Lamé (22).

5. Procédé de réalisation d'un résonateur électromécanique selon la revendication 1 destiné à fonctionner à une fréquence de résonance donnée, comprenant les étapes suivantes :

- sélection de la forme de la structure suspendue,
- sélection des dimensions de la structure suspendue afin qu'un de ses modes propres corresponde à la fréquence de résonance donnée,
- sélection de la forme et de l'emplacement de la structure d'ancrage destinée à résonner à la fréquence de résonance donnée,
- modélisation de la structure suspendue et de la structure d'ancrage afin de déterminer les dimensions de la structure d'ancrage considérée afin que l'ensemble des deux structures résonne à la même fréquence,
- fabrication du résonateur à partir des données fournies aux étapes précédentes.

**Patentansprüche**

1. Elektromechanischer Resonator, welcher auf einem Substrat realisiert ist, wobei der Resonator Folgendes umfasst:

- eine Aufhängungsstruktur (32), welche zumindest teilweise aus dem Substrat (31) realisiert ist, wobei die Struktur dazu bestimmt ist, in Schwingung versetzt zu werden, um zumindest in einer Resonanzfrequenz zu schwingen, welche der Aufhängungsstruktur eigen ist;
- eine Verankerungsstruktur (34) zur Verankerung der Aufhängungsstruktur an zumindest einem Bereich ihres Randes, wobei die Verankerungsstruktur an dem restlichen Substrat so bemessen ist, dass sie in der besagten Resonanzfrequenz schwingt;
- Mittel zur Anregung der Aufhängungsstruktur, um diese in der besagten Resonanzfrequenz in Schwingung zu versetzen;
- Mittel zur Detektion der Schwingungsfrequenz der Aufhängungsstruktur;
**dadurch gekennzeichnet, dass**:
- die Verankerungsstruktur zumindest ein T-förmiges Element (34) umfasst, welches aus einem mit dem Substrat (31) fest verbundenen ersten beidseitig eingespannten Balken (35) und aus einem zweiten Balken (36) gebildet ist, dessen erstes Ende fest mit dem ersten Balken verbunden ist und dessen zweites Ende fest mit der Aufhängungsstruktur (32) verbunden ist;
- die Aufhängungsstruktur im Lame-Modus oder im Weinglas-Modus schwingt, wobei das erste Ende des zweiten Balkens (36) fest mit dem ersten Balken (35) an einem Schwingungsknoten des ersten Balkens (35) verbunden ist, und das zweite Ende des zweiten Balkens (36) fest mit der Aufhängungsstruktur (32) an deren Knotenpunkt verbunden ist.

2. Elektromechanischer Resonator nach Anspruch 1, in welchem die Aufhängungsstruktur eine Struktur ist, welche aus einer Scheibe, einer quadratischen Platte, einer rechteckigen Platte, einem Ring und einer Ellipse ausgewählt wird.

**3.** Elektromechanischer Resonator nach Anspruch 2, in welchem die Aufhängungsstruktur eine Scheibe oder eine Ellipse ist, welche in dessen "Weinglas"-Modus (32) schwingt.

**4.** Elektromechanischer Resonator nach Anspruch 2, in welchem die Aufhängungsstruktur eine quadratische oder rechteckige Platte ist, welche in dessen sogenannten Lame-Modus (22) schwingt.

**5.** Verfahren zur Herstellung eines elektromechanischen Resonators nach Anspruch 1, welcher zum Arbeiten in einer vorgegebenen Resonanzfrequenz bestimmt ist, wobei das Verfahren die folgenden Schritte umfasst:

- Auswahl der Form der Aufhängungsstruktur;
- Auswahl der Abmessungen der Aufhängungsstruktur, damit einer ihrer Eigenmoden einer gegebenen Resonanzfrequenz entspricht;
- Auswahl der Form und des Standorts der Verankerungsstruktur, welche zur Schwingung in der vorgegebenen Resonanzfrequenz bestimmt ist;
- Modellierung der Aufhängungsstruktur und der Verankerungsstruktur, um die Abmessungen der erwägten Verankerungsstruktur zu bestimmen, damit die Gesamtheit der beiden Strukturen in derselben Frequenz schwingt;

Herstellung des Resonators mit den in den vorhergehenden Schritten bereitgestellten Daten.

**Claims**

**1.** An electromechanical resonator produced on a substrate, comprising:

- a suspended structure (32) produced at least partly from the substrate (31), configured to be vibrated to resonate at at least one natural resonance frequency of the suspended structure;
- an anchor structure (34) to anchor the suspended structure, by at least one area of its periphery, to the remainder of the substrate, wherein the anchor structure is dimensioned to resonate at said resonance frequency;
- means for exciting the suspended structure, to cause it to vibrate at said resonance frequency;
- means for detecting the vibration frequency of the suspended structure, **characterized in that**:
- the anchor structure includes at least one T-shaped element (34) formed from a first fixed-fixed beam (35), coupled with the substrate (31), and a second beam (36) a first end of which is coupled with the first beam, and a second end of which is coupled with the suspended structure (32),
- the suspended structure resonates in Lamé mode or in wine-glass mode, the first end of the second beam (36) is coupled with the first beam (35) at a node of vibration of the first beam (35), and the second end of the second beam (36) is coupled with the suspended structure (32) at a nodal point of the latter.

**2.** An electromechanical resonator according to claim 1, in which the suspended structure is a structure chosen from among a disk, a square plate, a rectangular plate, a ring, and an ellipse.

**3.** An electromechanical resonator according to claim 2, in which the suspended structure is a disk or an ellipse resonating in its wine-glass mode.

**4.** An electromechanical resonator according to claim 2, in which the suspended structure is a square or rectangular plate resonating in its Lamé mode.

**5.** A method of manufacture of an electromechanical resonator according to claim 1, configured to operate at a given resonance frequency, the method comprising:

- selecting the shape of the suspended structure;
- selecting the dimensions of the suspended structure so that one of its natural modes is the given resonance frequency;
- selecting the shape and position of the anchor structure intended to resonate at the given resonance frequency;
- modelling the suspended structure and the anchor structure, to determine the dimensions of the anchor structure considered, so that both the structures may resonate at the same frequency;
- manufacturing the resonator using the data supplied in the previous steps.

FIG. 1

FIG. 2

FIG. 3

FIG. 4

FIG. 5

FIG. 6

**FIG. 7**

**FIG. 8**

FIG. 9A

FIG. 9B

FIG. 9C

FIG. 9D

FIG. 10A

FIG. 10B

**FIG. 10C**

**FIG. 10D**

**FIG. 10E**

FIG. 10F

FIG. 10G

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE V. KAAJAKARI.** Square-Extensional Mode Single-Crystal Silicon Micromechanical Resonator for Low-Phase-Noise Oscillator Applications. *IEEE Electron Devices Letters,* Avril 2004, vol. 25 (4), 173-175
- **YU-WEI LIN et al.** 60 MHz wine-glass micromechanical-disk reference oscillator. *ISSCC, Digest of Techical Papers,* 15 Février 2004, vol. 530, 322-323

- **K. SUNDARESAN et al.** A low phase noise 100 MHz silicon BAW reference oscillator. *IEEE CICC,* 10 Septembre 2006, 841-844
- **L. KHINE et al.** High-Q bulk-mode SOI square resonators with straight-beam anchors. *J. Micromech. Microeng.,* 01 Janvier 2009, vol. 19 (1), 015017
- **V. KAAJAKARI.** Square-Extensional Mode Single-Crystal Silicon Micromechanical Resonator for Low-Phase-Noise Oscillator Applications. *IEEE Electron Devices Letters,* Avril 2004, vol. 25 (4), 173-175